# EUROPEAN PATENT APPLICATION

(11) **EP 4 621 926 A1**
(43) Date of publication of application: **24.09.2025**
(21) Application number: 25165059.4
(22) Date of filing: 20.03.2025
(51) Int. Cl.: H01M 10/42, H05K 1/02

(54) **BATTERY PROTECTION BOARD, BATTERY APPARATUS AND POWER CONSUMING DEVICE**

(30) Priority: 20.03.2024 CN 202420574374 U
(71) Applicant: BYD Company Limited, Shenzhen, Guangdong 518118 (CN)
(72) Inventor: LI, Ruijie, Shenzhen, 518118 (CN); HAN, Pengwei, Shenzhen, 518118 (CN); HUANG, Jinshui, Shenzhen, 518118 (CN)
(74) Representative: Mathys & Squire

(57) **Abstract**

A battery protection board, a battery apparatus and a power consuming device. The battery protection board includes a circuit board and a first conductive member. The circuit board includes a board body, a first conductive path and a second conductive path. The first conductive path and the second conductive path are both disposed on the board body and insulated from each other. The first conductive path is adapted to be electrically connected to a first electrode of a battery core, and the second conductive path is adapted to be electrically connected to a second electrode of the battery core. Polarities of the first electrode and the second electrode are opposite. The first conductive member is mounted to the board body and connected in parallel with at least part of the first conductive path. The first conductive member is provided to be connected in parallel with at least part of the first conductive path of the circuit board, and the first conductive member is directly mounted to the circuit board to be a whole, which not only reduces internal traces of the board body and saves an internal space of the board body, but also does not need additional assembly, thereby reducing procedures and costs and facilitating automatic mass production.

## Description

### FIELD

The present disclosure relates to the technical field of batteries, and specifically, to a battery protection board, a battery apparatus and a power consuming device.

### BACKGROUND

With the rapid development of mobile phone fast charging technology, high-power charging has increasingly high requirements for batteries. During high-current charging and discharging, requirements for a temperature rise of batteries are also relatively high. This poses large challenges to a design of battery protection boards and a design of structural parts.

In an existing battery protection board, a conductive assembly is additionally added outside a circuit board to reduce internal resistance of a battery, and the conductive assembly needs to be additionally welded to a battery core and the protection board, resulting in complicated procedures and high costs.

### SUMMARY

An objective of the present disclosure is to provide a battery protection board, a battery apparatus and a power consuming device, to reduce procedures and costs.

To achieve the objective of the present disclosure, the present disclosure provides the following technical solutions:

In a first aspect, the present disclosure provides a battery protection board, including a circuit board and a first conductive member. The circuit board includes a board body, a first conductive path and a second conductive path. The first conductive path and the second conductive path are both disposed on the board body and insulated from each other. The first conductive path is suitable for being electrically connected to a first electrode of a battery core, and the second conductive path is suitable for being electrically connected to a second electrode of the battery core. Polarities of the first electrode and the second electrode are opposite. The first conductive member is mounted to the board body and connected in parallel with at least part of the first conductive path.

In an implementation, the board body includes a first surface and a second surface that face away from each other, and the battery protection board further includes a first pad. The first pad is disposed on the first surface, and the first conductive member is mounted to the second surface. Both the first conductive member and the first conductive path are electrically connected to the first pad.

In an implementation, the board body is provided with a via hole running through the first surface and the second surface, and the first conductive member is electrically connected to the first pad through the via hole.

In an implementation, the battery protection board further includes an electronic element. The electronic element is mounted to the second surface, and the electronic element and the first conductive member are spaced away.

In an implementation, the circuit board is coated with a first insulation layer, and/or the first conductive member is coated with a second insulation layer.

In an implementation, the battery protection board further includes a second pad. The second pad is disposed on the first surface and spaced away from the first pad, and the second pad is electrically connected to the second conductive path.

In an implementation, the first conductive member is coated with a first insulation layer, and/or the circuit board and the first conductive member are coated with a second insulation layer.

In an implementation, the battery protection board further includes a second conductive member. The second conductive member is mounted to the board body and connected in parallel with at least part of the second conductive path.

In an implementation, the battery protection board further includes a first flexible extension board and a second flexible extension board. The first flexible extension board and the second flexible extension board each are connected to the circuit board. The first conductive path and the second conductive path are electrically connected to the first flexible extension board. The first conductive member is electrically connected to the second flexible extension board.

In an implementation, the circuit board further includes a third conductive path. The third conductive path is disposed on the board body and insulated from the first conductive path and the second conductive path, and the third conductive path is electrically connected to the second flexible extension board.

In a second aspect, the present disclosure further provides a battery apparatus, including a battery core and the battery protection board according to any one of the various implementations of the first aspect. The battery core is connected to the first electrode and the second electrode. The first conductive path is electrically connected to the first electrode, and the second conductive path is electrically connected to the second electrode.

In a third aspect, the present disclosure further includes a power consuming device, including a power consuming apparatus and the battery apparatus according to the second aspect. The battery apparatus supplies power to the power consuming apparatus.

With the arrangement of the circuit board and the first conductive member, the first conductive path and the second conductive path of the circuit board are spaced away on the board body of the circuit board. The first conductive path is electrically connected to the first electrode of the battery core, and the second conductive path is electrically connected to the second electrode, with an opposite polarity, of the battery core. A line where the first conductive member is located is connected in parallel with at least part of the first conductive path, and the first conductive member is directly mounted to the circuit board to be a whole without additional assembly, thereby reducing procedures and costs, and facilitating automatic mass production.

### BRIEF DESCRIPTION OF THE DRAWINGS

To describe the technical solutions in the implementations of the present disclosure or the related art more clearly, the accompanying drawings required for describing the implementations or the related art are briefly described below. Clearly, the accompanying drawings in the following description show some implementations of the present disclosure only, and a person of ordinary skill in the art may still derive other drawings from these accompanying drawings without creative efforts.
FIG. 1 is a front view of a battery apparatus according to an embodiment;
FIG. 2 is a front view of a battery core according to an embodiment;
FIG. 3 is a front view of a battery apparatus in an unfolded state of a battery protection board according to an embodiment;
FIG. 4 is a rear view of a battery apparatus in an unfolded state of a battery protection board according to an embodiment;
FIG. 5 is a schematic diagram of a battery apparatus according to an embodiment; and
FIG. 6 is a rear view of a battery apparatus in an unfolded state of a battery protection board according to another embodiment.

In the drawings:
100 - Battery apparatus;
10 - battery core, 11 - second electrode, 12 - first electrode;
20 - battery protection board, 21 - circuit board, 211 - board body, 212 - first conductive path, 213 - second conductive path, 214 - first surface, 215 - second surface, 216 - third conductive path, 22 - first conductive member, 221 - first SMT pad, 222 - second SMT pad, 23 - first pad, 24 - second pad, 25 - electronic element, 26 - first flexible extension board, 261 - first output terminal, 27 - second flexible extension board, 271 - second output terminal;
30 - first connecting sheet;
40 - second connecting sheet.

### DETAILED DESCRIPTION

The technical solutions in implementations of the present disclosure are described below clearly and completely with reference to the accompanying drawings in the implementations of the present disclosure. Clearly, the described implementations are merely some, rather than all of the implementations of the present disclosure. All other implementations derived from the implementations of the present disclosure by a person of ordinary skill in the art without creative efforts shall fall within the protection scope of the present disclosure.

It should be noted that when an assembly is "fixed" to another assembly, the assembly may be directly on the another assembly, or an intermediate assembly may exist. When an assembly is considered as being "connected" to another assembly, the assembly may be directly connected to the another assembly or an intermediate assembly may exist.

Unless otherwise defined, all technical and scientific terms used in the present disclosure have the same meanings as commonly understood by a person skilled in the technical field to which the present disclosure belongs. The terms used in the specification in the present disclosure are merely intended to describe the specific embodiments, rather than to limit the present disclosure. As used in the present disclosure, the term "and/or" includes any and all combinations of one or more related listed items.

Some implementations of the present disclosure are described in detail below with reference to the accompanying drawings. Without conflict, the following embodiments and features in the embodiments may be combined with each other.

An embodiment of the present disclosure provides a power consuming device, including a power consuming apparatus and a battery apparatus according to an embodiment of the present disclosure. The battery apparatus supplies power to the power consuming apparatus.

Optionally, the power consuming apparatus may be a mobile phone, an electric vehicle, a hybrid electric vehicle, a base station, a household power consuming load, or the like.

Optionally, the battery apparatus may be a power battery apparatus, an energy storage battery apparatus, or the like, which is not specifically restricted.

The battery apparatus according to the embodiment of the present disclosure is adopted for the power consuming device, which can reduce procedures and costs.

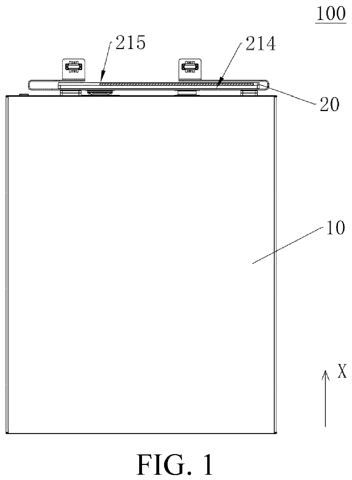

Referring to FIG. 1, an embodiment of the present disclosure further provides a battery apparatus 100, including a battery core 10 and a battery protection board 20 according to an embodiment of the present disclosure.

A direction is defined first, as shown in FIG. 1. X is a lengthwise direction of the battery core 10.

Optionally, the battery core 10 may be a pouch battery core 10, a steel shell battery core 10, or the like, which is not restricted.

Optionally, as shown in FIG. 1, the battery core 10 is a steel shell battery core 10. Optionally, a first electrode 12 and a second electrode 11 are connected to an end of the battery core 10 in the lengthwise direction X, and polarities of the first electrode 12 and the second electrode 11 are opposite.

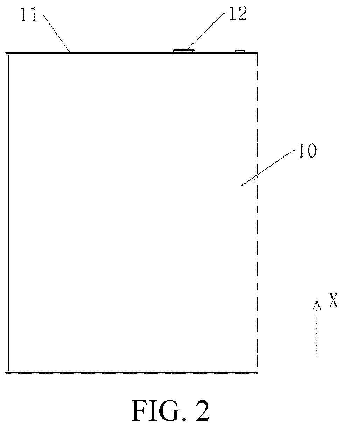

Optionally, the first electrode 12 is a positive tab, the second electrode 11 is a negative tab, and the positive tab and the negative tab are disposed on the same side of the battery core 10. Alternatively, as shown in FIG. 2, a cover plate and a rivet are included at an end of the battery core 10 in the lengthwise direction X. The first electrode 12 of the battery core 10 is the rivet with a positive polarity, and the second electrode 11 of the battery core 10 is the cover plate with a negative polarity. Each of the above methods can be used, and is not specifically restricted.

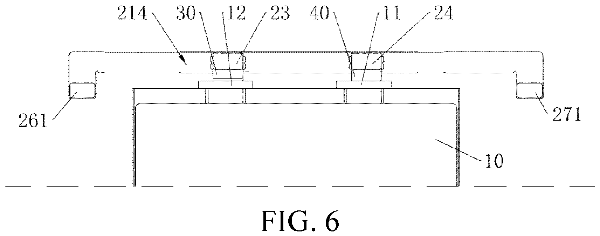

Optionally, in another embodiment, as shown in FIG. 6, the battery core 10 is a pouch battery core 10. A first electrode 12 and a second electrode 11 are connected to an end of the battery core 10 in the lengthwise direction X. The first electrode 12 has a positive polarity and the second electrode 11 has a negative polarity.

Optionally, the battery protection board 20 is disposed, in the lengthwise direction X, at an end of the battery core 10 to which the first electrode 12 and the second electrode 11 are connected.

Optionally, the number of battery cores 10 may be one or more, and is not restricted. When there are multiple battery cores 10, the multiple battery cores 10 are electrically connected to each other. The battery protection board 20 can be also used in multi-series connection battery packs or multi-parallel connection battery packs, such as 2S1P, 3S1P, 4S1P, 2S2P, 3S2P and other different series-parallel structures, where 1S denotes that the number of battery cores 10 connected in series is 1, and 1S denotes that the number of batteries connected in parallel is 1, and so on. Details are not described.

Optionally, the battery apparatus 100 further includes a housing, and the housing includes a bottom plate and multiple side plates. The side plates are connected to the bottom plate and enclose to form an accommodating cavity. An end of the accommodating cavity opposite to the bottom plate is open, and the battery core 10 is accommodated in the accommodating cavity.

The housing is made of a material with a high structural strength, which may be specifically a metal material, high-strength plastic, ceramics, or the like. The metal material is, for example, aluminum, an aluminum alloy, a magnesium alloy, iron and an iron alloy. The housing may be of an integrated structure, that is, the bottom plate and the side plates are of an integrated structure made by an integrated molding process. The integrated molding process may be specifically stamping, casting, or the like, which is not restricted. The housing may alternatively be of a split structure, and the side plates and the bottom plate can be connected and fixed by welding, bonding, clamping, screwing, or the like. A wall thickness at each part of the housing may be approximately uniform. That is, thicknesses of the side plates may be approximately uniform, and thicknesses of the bottom plate and the side plates may be also approximately the same.

Optionally, the battery apparatus 100 further includes a top plate, and the top plate is connected at an opening of the housing, thereby sealing the accommodating cavity. A method for connecting the top plate to the housing may be welding, bonding, clamping, screwing, or the like, which is not restricted. The shape of the top plate may be approximately the same as that of the bottom plate.

The battery apparatus 100 according to the embodiment of the present disclosure can reduce procedures and costs by adopting the battery protection board 20 according to the embodiment of the present disclosure.

The battery protection board 20 according to the embodiment of the present disclosure is described in detail below.

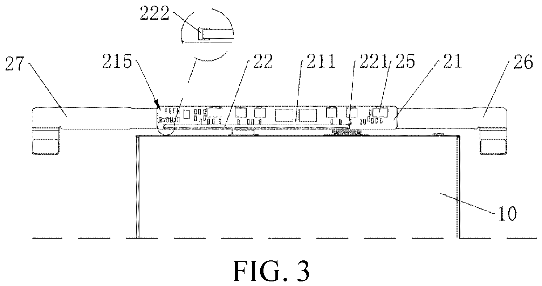

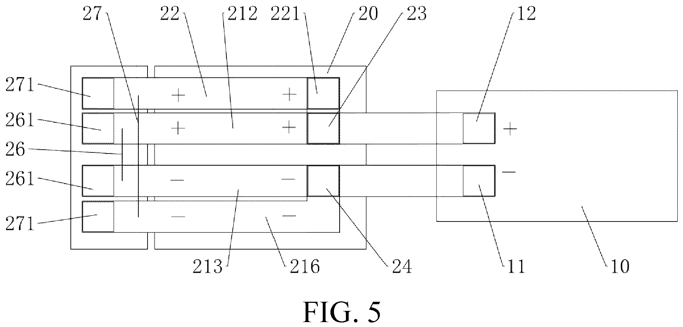

Referring to FIGS. 3 and 5, an embodiment of the present disclosure provides a battery protection board 20, including a circuit board 21 and a first conductive member 22.

Optionally, the circuit board 21 includes a board body 211, a first conductive path 212 and a second conductive path 213. The first conductive path 212 and the second conductive path 213 are spaced away on the board body 211. The first conductive path 212 is suitable for being electrically connected to a first electrode 12 of a battery core 10, and the second conductive path 213 is suitable for being electrically connected to a second electrode 11 of the battery core 10.

Optionally, the circuit board 21 may be a circuit board 21 commonly used in this field, such as a flexible printed circuit board 21, a rigid circuit board 21, a rigid-flex integrated circuit board 21, a rigid-flex combined circuit board 21, a printed circuit board (PCB) 21 or a ceramic circuit board 21, which is not specifically restricted.

Optionally, the board body 211 of the circuit board 21 includes a printed circuit board part and a flexible printed circuit board part, and the two parts form the board body 211 by a board-making process.

Optionally, the board body 211 may be rectangular, square, circular, irregularly polygonal, or the like, which is not specifically restricted.

Optionally, the first conductive path 212 and the second conductive path 213 are internal traces of the circuit board 21, and the first conductive path 212 and the second conductive path 213 are disposed inside the board body 211. The traces may be disposed manually or by an automatic wiring tool, which is not specifically restricted.

Optionally, one of the first conductive path 212 and the second conductive path 213 is connected to the cover plate of the battery core 10, and the other is connected to the rivet of the battery core 10.

Optionally, the first conductive member 22 is mounted to the board body 211, and a line where the first conductive member 22 is located is connected in parallel with a line of the first conductive path 212.

Optionally, the first conductive member 22 is a block-shaped cuboid conductive member, and the first conductive member 22 may be made of copper, aluminum, silver, steel, or the like, which is not specifically restricted.

Optionally, the first conductive member 22 is mounted to the board body 211 by a surface mount technology (SMT). This technology is a technology that can directly mount a component on a surface of the circuit board 21, instead of inserting a component into a slot of the circuit board 21 like a conventional PCB. The SMT has the advantages of high assembly density, high reliability, strong anti-vibration ability, ease of automation, and the like.

Optionally, the circuit board 21 includes a first SMT pad 221 and a second SMT pad 222. The first conductive member 22 is mounted on the first SMT pad 221 and the second SMT pad 222 when mounted on the board body 211.

Optionally, the first conductive member 22 is made of copper, and a joint between the first conductive member 22 and the first SMT pad 221 and a joint between the first conductive member 22 and the second SMT pad 222 need to be tinned, which facilitates implementation of an SMT condition by the first conductive member 22. If a first conductive member 22 made of another conductive material is used, the SMT condition also needs to be met. A tinned area on the first conductive member 22 also needs to meet requirements for welding tension while meeting the surface mount condition, so as to prevent falling off after surface mount.

Optionally, the first SMT pad 221 and the second SMT pad 222 each include multiple sub-pads, so as to increase welding tension of the first SMT pad 221 and the second SMT pad 222 on the first conductive member 22 and prevent the first conductive member 22 from falling off. Joints between the multiple sub-pads and the first conductive member 22 also need to be tinned.

Optionally, the battery protection board 20 further includes a first flexible extension board 26 and a second flexible extension board 27. The first flexible extension board 26 and the second flexible extension board 27 each are connected to the circuit board 21. The first conductive path 212 and the second conductive path 213 are electrically connected to the first flexible extension board 26, and the first conductive member 22 is electrically connected to the second flexible extension board 27.

Optionally, the first flexible extension board 26 is connected to one end of a flexible board part of the circuit board 21, and the second flexible extension board 27 is connected to the other end facing away from the flexible board part of the circuit board 21. The connection method may be laser welding, hot-pressing welding, clamping, or the like, which is not specifically restricted.

Optionally, the first flexible extension board 26 and the second flexible extension board 27 may be of an integrated structure or a split structure, which is not specifically restricted.

Optionally, the first flexible extension board 26 is provided with a first output terminal 261. One end of the first conductive path 212 is connected to the first electrode 12, and the other end thereof is directly or indirectly electrically connected to a positive electrode of the first output terminal 261, which is not specifically restricted. For example, the first conductive path 212 can extend to the first flexible extension board 26 and be directly electrically connected to the positive electrode of the first output terminal 261. The first conductive path 212 is electrically connected to a trace on the first flexible extension board 26, and the trace on the first flexible extension board 26 is electrically connected to the positive electrode of the first output terminal 261, thereby electrically connecting the first electrode 12 to the positive electrode of the first output terminal 261.

Optionally, the second flexible extension board 27 is provided with a second output terminal 271, and the first conductive member 22 is directly or indirectly connected to a positive electrode or a negative electrode of the second output terminal 271, which may refer to the above-mentioned method for connecting the first conductive path 212 to the first output terminal 261. Details are not described.

Optionally, the circuit board 21 further includes a third conductive path 216, and the third conductive path 216 is disposed on the board body 211 and insulated from the first conductive path 212 and the second conductive path 213. The third conductive path 216 is electrically connected to the negative electrode of the second output terminal 271.

Optionally, the first conductive member 22 is electrically connected to the positive electrode of the second output terminal 271, the second conductive path 213 is electrically connected to a negative electrode of the first output terminal 261, and the third conductive path 216 is electrically connected to the negative electrode of the second output terminal 271, all of which are in a connection method similar to the above-mentioned method for connecting the first conductive path 212 to the first flexible extension board 26. Reference may be made, and details are not described.

The third conductive path 216 of the circuit board 21 is disposed on the board body 211 and electrically connected to the negative electrode of the second output terminal 271, so that the positive electrode of the second output terminal 271, the first conductive member 22, the third conductive path 216 and the negative electrode of the second output terminal 271 are electrically connected. This can reduce overall internal resistance of the battery apparatus 100 and increase power of the battery apparatus 100.

Optionally, the first conductive path 212 and the second conductive path 213 form a first electrical connector with the positive electrode and the negative electrode of the first output terminal 261. The first conductive member 22 and the third conductive path 216 form a second electrical connector with the positive electrode and the negative electrode of the second output terminal 271.

Optionally, the line where the first conductive member 22 is located may be connected in parallel with the whole line of the first conductive path 212. For example, the first conductive member 22 is connected to the rivet of the battery core 10 and the positive electrode of the second output terminal 271 of the second flexible extension board 27. The line where the first conductive member 22 is located may alternatively be connected in parallel with part of the line of the first conductive path 212. The first conductive member 22 can be added to any line that needs shunting and reduction of internal resistance, which is not specifically restricted.

The battery protection board 20 further includes a first flexible extension board 26 and a second flexible extension board 27. The first flexible extension board 26 and the second flexible extension board 27 each are connected to the circuit board 21. The first conductive path 212 and the second conductive path 213 are electrically connected to the first flexible extension board 26, and the first conductive member 22 is electrically connected to the second flexible extension board 27, thereby electrically connecting the battery core 10 and the battery protection board 20 to the outside.

Optionally, the battery protection board 20 further includes a second conductive member (not shown in the figure), and the second conductive member is mounted to the board body 211. A line where the second conductive member is located is connected in parallel with the second conductive path 213.

Optionally, a material of the second conductive member and a method for connecting the second conductive member to the board body 211 are similar to those of the aforementioned first conductive member 22. Reference may be made, and details are not described.

Optionally, the second conductive member may be connected in parallel with the whole second conductive path 213. For example, the second conductive member is connected to the cover plate of the battery core 10 and the negative electrode of the second output terminal 271 of the second flexible extension board 27. The second conductive member may alternatively be connected in parallel with part of the line of the second conductive path 213. The second conductive member can be added to any line that needs shunting and reduction of internal resistance, which is not specifically restricted.

The battery protection board 20 further includes the second conductive member. The second conductive member is mounted to the board body 211, and the line where the second conductive member is located is connected in parallel with the second conductive path 213, so that overall internal resistance of the battery apparatus 100 can be reduced, thereby increasing power of the battery apparatus 100, and greatly reducing a temperature rise during charging and discharging.

With the rapid development of mobile phone fast charging technology, high-power charging has increasingly high requirements for batteries. During high-current charging and discharging, requirements for a temperature rise of batteries are also relatively high. This requires a current withstand value of a line to be increasingly large. Methods for increasing a current withstand value of a line are as follows: A copper foil thickness and a line width of a line are increased. When the width of the battery protection board 20 and the thickness of the battery protection board 20 still cannot meet design requirements when reaching a limit, it is considered to add a parallel circuit of a high current line based on an internal line of the battery protection board 20 to increase the current withstand value of the line.

In the related art, an added parallel line is an additional conductive assembly, which need to be welded with to a tab of the battery core 10 and the protection board, resulting in complicated procedures and high cost. Moreover, due to different welding positions and welding requirements, it is very difficult to implement production automation in practical application, which is not conducive to mass production of products.

In the battery protection board 20 according to the embodiment of the present disclosure, with the arrangement of the circuit board 21 and the first conductive member 22, the first conductive path 212 and the second conductive path 213 of the circuit board 21 are spaced away on the board body 211 of the circuit board 21. The first conductive path 212 and the second conductive path 213 are connected to electrodes of the battery core 10 with opposite polarities respectively. A circuit where the first conductive member 22 is located is connected in parallel with the first conductive path 212, and the first conductive member 22 is mounted to the circuit board 21 to be a whole without additional assembly, thereby reducing procedures and costs, and facilitating automatic mass production.

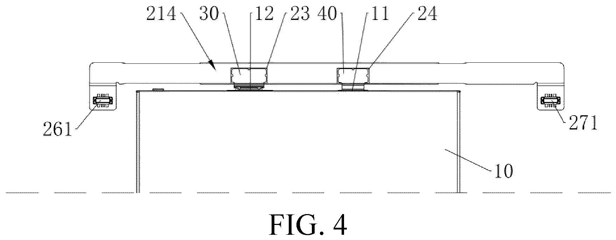

Optionally, as shown in FIGS. 3 and 4, the board body 211 includes a first surface 214 and a second surface 215 that face away from each other, and the battery protection board 20 further includes a first pad 23. The first pad 23 is disposed on the first surface 214, and the first conductive member 22 is mounted to the second surface 215. Both the first conductive member 22 and the first conductive path 212 are electrically connected to the first pad 23.

Optionally, the first pad 23 may be made of a pad material commonly used in this field, such as nickel, nickel plated copper, a tin-copper alloy, a gold-plated material, or the like, which is specific not restricted.

Optionally, the first pad 23 and the board body 211 may be connected through mounting, welding, or the like, which is not specifically restricted.

Optionally, the first pad 23 is mounted to the first surface 214, and the first conductive member 22 is mounted to the second surface 215 through the first SMT pad 221 and the second SMT pad 222.

Optionally, the battery apparatus 100 further includes a first connecting sheet 30, and the first electrode 12 of the battery core 10 is connected to the first pad 23 through the first connecting sheet 30. The connection method may be welding, bonding, mounting, or the like, which is not specifically restricted.

Optionally, the first connecting sheet 30 is an L-shaped nickel sheet. One end of the first connecting sheet is mounted to the first pad 23 by the SMT, and the other end thereof is welded to the first electrode 12 by package spot welding.

The board body 211 includes a first surface 214 and a second surface 215 that face away from each other, and the battery protection board 20 further includes a first pad 23. The first pad 23 is disposed on the first surface 214, and the conductive member is mounted to the second surface 215. Both the first conductive member 22 and the first conductive path 212 are electrically connected to the first pad 23. The first conductive member 22 and the pads are disposed on the surfaces of the board body 211 that face away from each other, which can avoid short circuit between pads caused by uncertain factors in the related art and improve use safety.

Optionally, the battery protection board 20 further includes a second pad 24. The second pad 24 is disposed on the first surface 214 and spaced away from the first pad 23, and the second pad 24 is electrically connected to the second conductive path 213.

Optionally, the second pad 24 is further electrically connected to the third conductive path 216.

Optionally, a material of the second pad 24 and a method for connecting the second pad 24 to the board body 211 are similar to those of the aforementioned first pad 23. Reference may be made, and details are not described.

For example, as shown in FIG. 4, the first electrode 12 is a rivet, and the second electrode 11 is a cover plate. The first pad 23 is electrically connected to the rivet by a first connecting sheet 30, and the second pad 24 is electrically connected to the cover plate by a second connecting sheet 40, so that after the battery protection board 20 is connected to the positive electrode and the negative electrode of the battery core 10, during battery charging and discharging, a current flows through each trace of the first conductive member 22 and the circuit board 21 to increase the current withstand value of the battery protection board 20.

Optionally, in another embodiment, as shown in FIG. 6, the battery core 10 is a pouch battery core 10. The first pad 23 is electrically connected to the first electrode 12 by a first connecting sheet 30, and the second pad 24 is electrically connected to the second electrode 11 by a second connecting sheet 40.

The battery protection board 20 further includes a second pad 24. The second pad 24 is disposed on the first surface 214 and spaced away from the first pad 23, and the second pad 24 is electrically connected to the second conductive path 213, thereby avoiding short circuit between pads caused by uncertain factors in the related art and improving use safety.

Optionally, the board body 211 is provided with a via hole (not shown in the figure) running through the first surface 214 and the second surface 215, and the first conductive member 22 is electrically connected to the first pad 23 through the via hole.

Optionally, the via hole may be circular, square, triangular, or the like, and the number of via holes may be one or more. An appropriate number can be set based on a calculated current withstand value of an actual line, and the number is not specifically restricted. The via hole can implement an electrical connection between different layers of the circuit board 21, and enhance performance and reliability of the circuit design.

The board body 211 is provided with the via hole running through the first surface 214 and the second surface 215, and the via hole electrically connects the first surface 214 to the second surface 215, thereby electrically connecting the first conductive member 22 to the first pad 23.

Optionally, as shown in FIG. 3, the battery protection board 20 further includes an electronic element 25. The electronic element 25 is mounted to the second surface 215, and the electronic element 25 and the first conductive member 22 are spaced away.

Optionally, the circuit board 21 is formed by bonding a printed circuit board (PCB) 21 and a flexible printed circuit (FPC) board 21 together by a board-making process, and the circuit board 21 provides a surface mount environment for the electronic element 25 and line connection between circuits.

Optionally, the electronic element 25 mainly includes: a power management integrated circuit (IC), a protection IC 1, a protection IC 2, a metal oxide semiconductor (MOS), a precision detection resistor, a negative temperature coefficient (NTC) thermistor, an auxiliary resistor-capacitor, and the like.

The power management IC is an integrated circuit chip, which is configured to manage and control each aspect of a power supply system, and can monitor, adjust and protect a supply voltage, a voltage and power to ensure normal use of an electronic device, save power and prolong the service life of the battery core 10. The protection IC is also a control unit in a line. When abnormal charging and discharging occurs in a protection line, the protection IC controls an MOS transistor to operate and cut off a battery loop to protect the battery core 10 from a safety risk. The metal oxide semiconductor (MOS) is a switching unit, which is controlled by the IC to implement a closed or open state to protect the safety of the circuit. The precise detection resistor can detect a current value in the loop more accurately. The NTC is attached to the first surface 214 of the battery protection board 20 and is configured to collect a real-time temperature of the battery core 10. The auxiliary resistor-capacitor is configured to protect and assist a component in performing a protective function.

Optionally, the above electronic element 25 is mounted to the second surface 215 of the board body 211 by the SMT, and the battery apparatus 100 mainly implements the protective function and a communication function during circuit charging and discharging by the electronic element 25.

Optionally, the electronic element 25 may be connected in series and/or parallel with the first conductive path 212, and may be also connected in series and/or parallel with the second conductive path 213, which is not specifically restricted.

Optionally, when an internal design line of the circuit board 21 cannot meet requirements for design power of the battery pack, a conductive member may be connected in parallel at a position of a high current line to increase use power of the loop.

Optionally, the electronic element 25 and the first conductive member 22 are attached to the same surface of the board body 211. Compared with a method for additionally connecting the first conductive member 22 to the circuit board 21 by a connecting member in the related art, the thickness of the electronic element 25 can absorb the thickness of the first conductive member 22, so that the overall thickness of the battery protection board 20 is reduced.

The battery protection board 20 further includes the electronic element 25. The electronic element 25 is mounted to the second surface 215, and the electronic element 25 and the first conductive member 22 are spaced away, so that the overall thickness of the battery protection board 20 can be reduced, thereby saving an internal space occupied by the battery protection board 20 in the battery apparatus 100.

Optionally, the first conductive member 22 is coated with a first insulation layer, and/or the circuit board 21 and the first conductive member 22 are coated with a second insulation layer.

Optionally, the first conductive member 22 is externally coated with a first insulation layer, and the first insulation layer may be an insulating film or an insulating coating, or the first conductive member 22 is externally coated with an ultra violet (UV) adhesive and a conformal coating for insulation.

Optionally, the circuit board 21 and the first conductive member 22 are coated with a second insulation layer. The second insulation layer may be made of a resin material, such as an epoxy resin and a polyimide, or may be made of paper and a composite material thereof, a ceramic material, or the like, which is not specifically restricted.

Optionally, the circuit board 21 usually carries multiple circuits and components, and these circuits and components can be isolated by an insulating material to prevent short circuit, electric leakage, and other problems therebetween. Therefore, the circuit board 21 and the first conductive member 22 can be externally coated with an insulation layer to be isolated from the outside, so as to ensure stable operation and safe use of the circuit. Optionally, the first conductive member 22 and the circuit board 21 are encapsulated into a whole (system in package (SiP)) by EMC material molding. Electromagnetic compatibility (EMC) materials mean those materials that can suppress electromagnetic interference and reduce electromagnetic radiation. Molding packaging is a technology for encapsulating and protecting a bare chip with an epoxy resin molding compound.

Under a pressure and a temperature and by a mold, the circuit board 21 and the first conductive member 22 are encapsulated and protected with the epoxy resin molding compound, which can reduce an impact of electromagnetic interference on other devices and systems and reduce an impact of electromagnetic radiation on the environment and the human body. A device can be protected from external damage, and physical characteristics of the device are strengthened to facilitate use.

Optionally, the first conductive member 22 is coated with a first insulation layer, and a conventional circuit board 21 in this field is insulated. Therefore, there is no risk of short circuit between the first conductive member 22 and the circuit board 21. Alternatively, the first conductive member 22 and the circuit board 21 are coated together with a second insulation layer for insulation without additional insulation of the first conductive member, which can reduce material costs and design costs, and there is also no risk of short circuit. Alternatively, after the first conductive member 22 is coated with a first insulation layer, the first conductive member and the circuit board 21 are coated together with a second insulation layer. Each of the above methods can be used, and is not specifically restricted.

The circuit board 21 and the first conductive member 22 are coated with the first insulation layer, and/or the circuit board 21 and the first conductive member 22 are coated with the second insulation layer, so that the problems such as short circuit between circuits and electric leakage can be prevented, and the stable operation and safe use of the battery protection board 20 can be ensured.

Optionally, as shown in FIG. 1, after assembly of the battery protection board 20 is completed, the first surface 214 of the board body 211 faces the battery core 10, and the second surface 215 faces away from the battery core 10.

Optionally, the first pad 23 and the second pad 24 are mounted to the first surface 214, and the first surface 214 faces the battery core 10 to facilitate the connection between electrodes of the battery core 10 and the first pad 23 and the second pad 24 by connecting sheets. The first conductive member 22 is mounted to the second surface 215 to avoid short circuit between the first conductive member 22 and the pads caused by uncertain factors, thereby improving use safety.

The first surface 214 is provided to face the battery core 10, and the second surface 215 faces away from the battery core 10. The first pad 23 and the second pad 24 are disposed on the first surface 214, and the conductive member is mounted to the second surface 215, so that the battery protection board 20 is connected to the battery core 10, thereby avoiding crossing, which otherwise increases the risk of short circuit.

A battery apparatus 100 according to an embodiment of the present disclosure is described in detail below.

The battery apparatus 100 includes a battery core 10 and a battery protection board 20. The battery protection board 20 includes a circuit board 21 and a first conductive member 22. The first conductive member 22 is configured to shunt a first electrode 12 of the battery core 10 and a positive electrode of a first output terminal 261 of the battery protection board 20.

The battery core 10 includes a battery core 10 body, a rivet (positive polarity) and a cover plate (negative polarity). The cover plate and the rivet are connected to an end of the battery core 10 body in a lengthwise direction X. In this embodiment, the first conductive member 22 is made of copper, with a length ranging from 30 mm to 40 mm, a width ranging from 0.5 mm to 1.5 mm and a thickness ranging from 0.3 mm to 1.0 mm.

A surface of the first conductive member 22 in the embodiment of the present disclosure is not insulated. The first conductive member 22 is mounted to the circuit board 21 by a first SMT pad 221 and a second SMT pad 222. A joint between the first conductive member 22 and the first SMT pad 221 and a joint between the first conductive member 22 and the second SMT pad 222 are tinned. A manufacturing process requires that a single surface of a surface mount part of the first conductive member 22 is coated with matte tin, with a coating thickness ranging from 3 µm to 7 µm. After an electronic element 25 and the first conductive member 22 on the circuit board 21 are mounted to a first surface 214 of the circuit board 21, the battery protection board 20 is encapsulated by a SIP technology, so as to protect components, increase the overall strength of the battery protection board 20 and avoid stress concentration. Next, the battery apparatus 100 is assembled.

When the battery apparatus 100 is assembled, the battery protection board 20 is first in an unfolded state. A first pad 23 and a second pad 24 are connected to a second surface 215 of the circuit board 21 that faces away from the first surface 214. The positive-polarity rivet of the battery core 10 is welded to the first pad 23 of the battery protection board 20 by laser spot welding, and the negative-polarity cover plate is welded to the second pad 24 of the battery protection board 20 by laser spot welding. After the battery core 10 is connected to the battery protection board 20, normal charging and discharging functions of the battery apparatus 100 can be implemented.

Then, the battery protection board 20 is folded to a side of the cover plate that is away from the battery core 10 in the lengthwise direction X of the battery core 10, and the first surface 214 of the circuit board 21 faces the battery core 10, such that the first pad 23 and the second pad 24 of the battery protection board 20 are in contact with the rivet and the cover plate of the battery core 10 with the same polarity respectively. The second surface 215 to which the electronic element 25 and the first conductive member 22 are mounted faces away from the battery core 10. So far, the assembly of the battery core 10 and the battery protection board 20 is completed.

During discharging of the battery apparatus 100 according to the embodiment of the present disclosure, a first electrical connector and a second electrical connector of the positive electrode are connected in parallel for shunting, so as to implement current diversion together. A current of the first electrical connector of the positive electrode flows out from the positive electrode rivet of the battery core 10, flows to the first pad 23 of the battery protection board 20 through the first connecting sheet 30, flows to the positive electrode of the first output terminal 261 of the battery protection board 20 through the first conductive path 212 of the battery protection board 20, and finally flows in from the negative electrode cover plate. A current of the second electrical connector flows out from the positive electrode rivet of the battery core 10, flows to the first pad 23 of the battery protection board 20 through the first connecting sheet 30, and then flows into the first SMT pad 221 of the first conductive member 22 through a via hole of the circuit board 21. The current flows to the positive electrode of the second output terminal 271 of the battery protection board 20 through the first conductive member 22, and finally the current flows in from the negative electrode cover plate of the battery core 10, thereby implementing a discharging function of the battery core 10. During charging, the current in the battery apparatus 100 flows in the opposite direction. Reference may be made, and details are not described.

In the description of the embodiments of the present disclosure, it should be noted that an orientation or positional relationship indicated by the term "central", "upper", "lower", "left", "right", "vertical", "horizontal", "inner", "outer", or the like is based on the orientation or positional relationship based on the accompanying drawings. This is only for convenience of describing the present disclosure and simplifying the description, rather than indicating or implying that the referred apparatus or element needs to have a particular orientation, be constructed and operated in a particular orientation, and therefore should not be construed as limiting the present disclosure.

The above disclosed is only a preferred embodiment of the present disclosure and, certainly, cannot be used to limit the scope of the claims of the present disclosure. A person of ordinary skill in the art can understand all or part of the processes for implementing the above embodiment, and equivalent changes made based on the claims of the present disclosure shall still fall within the scope of the present disclosure.

## Claims

1. A battery protection board, comprising:
a circuit board comprising a board body, a first conductive path and a second conductive path, the first conductive path and the second conductive path being both disposed on the board body and insulated from each other, the first conductive path being adapted to be electrically connected to a first electrode of a battery core, the second conductive path being adapted to be electrically connected to a second electrode of the battery core, and polarities of the first electrode and the second electrode being opposite; and
a first conductive member being mounted to the board body and connected in parallel with at least part of the first conductive path.

2. The battery protection board according to claim 1, wherein the board body comprises a first surface and a second surface that face away from each other, the battery protection board further comprises a first pad, the first pad being disposed on the first surface, the first conductive member being mounted to the second surface, and both the first conductive member and the first conductive path being electrically connected to the first pad.

3. The battery protection board according to claim 2, wherein the board body is provided with a via hole running through the first surface and the second surface, and the first conductive member is electrically connected to the first pad through the via hole.

4. The battery protection board according to claim 2, further comprising an electronic element, the electronic element being mounted to the second surface, and the electronic element and the first conductive member being spaced away.

5. The battery protection board according to claim 2, further comprising a second pad, the second pad being disposed on the first surface and spaced away from the first pad, and the second pad being electrically connected to the second conductive path.

6. The battery protection board according to any one of claims 1 to 5, wherein the first conductive member is coated with a first insulation layer, and/or the circuit board and the first conductive member are coated with a second insulation layer.

7. The battery protection board according to claim 1, further comprising a second conductive member, the second conductive member being mounted to the board body and connected in parallel with at least part of the second conductive path.

8. The battery protection board according to claim 1, further comprising a first flexible extension board and a second flexible extension board, the first flexible extension board and the second flexible extension board each being connected to the circuit board, the first conductive path and the second conductive path being electrically connected to the first flexible extension board, and the first conductive member being electrically connected to the second flexible extension board.

9. The battery protection board according to claim 8, wherein the circuit board further comprises a third conductive path, the third conductive path being disposed on the board body and insulated from the first conductive path and the second conductive path, and the third conductive path being electrically connected to the second flexible extension board.

10. A battery apparatus, comprising a battery core and the battery protection board according to any one of claims 1 to 9, the battery core being connected to the first electrode and the second electrode, the first conductive path being electrically connected to the first electrode, and the second conductive path being electrically connected to the second electrode.

11. A power consuming device, comprising a power consuming apparatus and the battery apparatus according to claim 10, the battery apparatus supplying power to the power consuming apparatus.
